Europäisches Patentamt

European Patent Office

Office européen des brevets

(11) Numéro de publication:

**0 020 978**
**A1**

(12) **DEMANDE DE BREVET EUROPEEN**

(21) Numéro de dépôt: **80102570.1**

(22) Date de dépôt: **09.05.80**

(51) Int. Cl.³: **H 03 K 17/687,** H 01 L 27/06,
H 02 M 3/335

(30) Priorité: **12.06.79 FR 7915736**

(71) Demandeur: **International Business Machines Corporation, Armonk, N.Y. 10504 (US)**

(43) Date de publication de la demande: **07.01.81 Bulletin 81/1**

(72) Inventeur: **Jacquart, Christian, Chemin de Provence, F-06510 Gattieres (FR)**

(74) Mandataire: **Lattard, Nicole, COMPAGNIE IBM FRANCE Département de Propriété Industrielle, F-06610 La Gaude (FR)**

(84) Etats contractants désignés: **DE FR GB**

(54) **Dispositif de commutation et son application à une alimentation de puissance du type commuté.**

(57) Dispositif de commutation présentant des temps de commutation réduits et une résistance faible dans l'état fermé. Il comprend un transistor (21) du type V MOS par exemple et un transistor (20) du type NPN par exemple, montés en parallèle et recevant des impulsions de commande d'ouverture et de fermeture sur la grille (23) et sur la base (22). Ces impulsions sont telles que les fermetures des deux éléments (20) et (21) se produisent simultanément et que l'ouverture de (20) se produit avant celle de (21). Application aux alimentations de puissance du type commuté.

# DISPOSITIF DE COMMUTATION ET SON APPLICATION A UNE ALIMENTATION DE PUISSANCE DU TYPE COMMUTE

## Description

### Domaine Technique

La présente invention concerne un dispositif de commutation perfectionné qui présente des temps de commutation réduits et une résistance très faible dans l'état fermé, particulièrement bien adapté à l'utilisation dans une alimentation de puissance du type commuté.

Les dispositifs de commutation sont largement utilisés dans le domaine des circuits électroniques. Généralement sous commande de signaux, ils prennent l'un ou l'autre de deux états, dans un des états (état ouvert), ils ne laissent pas passer de courant et dans l'autre (état fermé), ils laissent le courant passer.

### Technique Antérieure

Ces dispositifs de commutation sont dans la majorité des applications constitués par de simples transistors bipolaires qui sous contrôle d'impulsions de commande appliquées sur leur base sont dans l'état conducteur (fermé) ou dans l'état bloqué (ouvert). Ces dispositifs dont les caractéristiques sont largement suffisantes pour de nombreuses applications présentent cependant des inconvénients qui les rendent peu efficaces dans les applications nécessitant des temps de commutation très courts et très précis comme par exemple dans les alimentations de puissance du type commuté où actuellement on cherche à réduire la taille des transformateurs. En effet cette réduction de taille peut être réalisée en augmentant la fréquence de découpage ce qui nécessite donc des commutateurs presque parfaits.

2

## Brève Description de l'Invention

En conséquence, un objet de la présente invention est de réaliser un dispositif de commutation très performant, c'est-à-dire qui présente des temps de commutation courts et une résistance très faible dans l'état conducteur.

Un autre objet de la présente invention est de réaliser un tel dispositif qui puisse être facilement intégré.

Le dispositif de la présente invention est constitué par la combinaison d'un transistor bipolaire et d'un transistor à effet de champ de préférence de type V MOS. Ces deux dispositifs sont disposés en parallèle c'est-à-dire que le collecteur du transistor bipolaire est connecté au drain du transistor à effet de champ et son émetteur est connecté à la source. Les signaux commandant l'ouverture et la fermeture du dispositif de commutation sont appliqués sur la base du transistor bipolaire et sur la grille du transistor à effet de champ, ces signaux ayant la même fréquence et étant tels que les deux transistors sont commandés simultanément pour la fermeture (état conducteur) mais l'ouverture (état bloqué) du transistor bipolaire est commandée pour se produire avant l'ouverture du transistor à effet de champ.

Cet arrangement permet de combiner les avantages des deux éléments. En effet le transistor à effet de champ a des vitesses de commutation plus grandes que le transistor bipolaire. Par contre, il présente une résistance relativement élevée dans l'état conducteur, ce qui fait qu'utilisé seul il ne constituerait pas un dispositif de commutation parfait. La résistance faible du transistor bipolaire lorsqu'il est conducteur permet de pallier cet inconvénient.

En conséquence, ce dispositif de commutation est particulièrement avantageux lorsqu'il est utilisé dans une alimentation de puissance du type commuté car il permet d'augmenter de façon importante la fréquence de découpage.

D'autres objets, caractéristiques et avantages de la présente invention ressortiront mieux de l'exposé qui suit, fait en référence aux dessins annexés à ce texte, qui représentent un mode de réalisation préféré de celle-ci.

## Brève description des figures

La figure 1 représente de façon schématique une alimentation du type commuté dans laquelle peut être incorporée la présente invention.

La figure 2 représente le dispositif de commutation conforme à l'invention.

La figure 3 représente la chronologie des signaux dans le dispositif de la figure 2.

## Description détaillée de l'invention

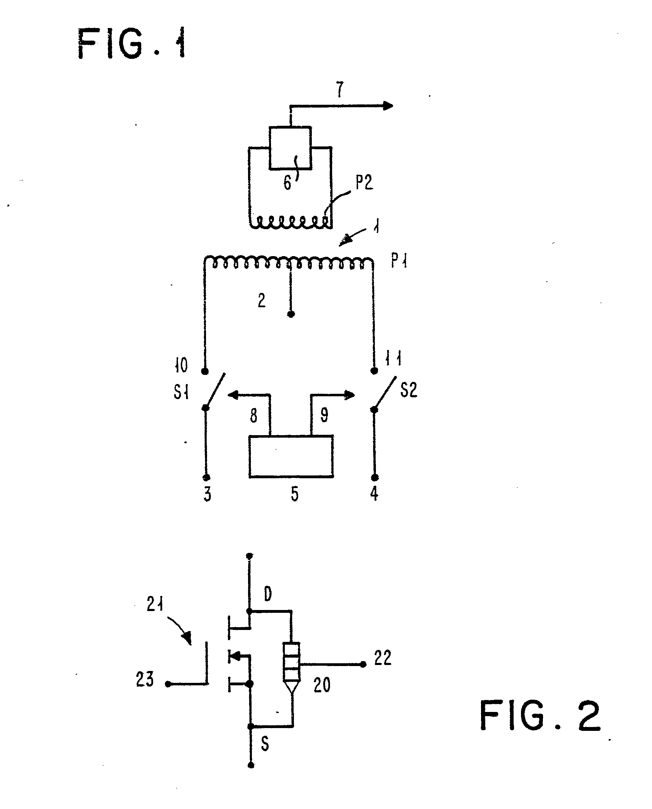

En référence à la figure 1, on va décrire le principe d'une alimentation de puissance du type commuté dans laquelle peut-être incorporé le dispositif de commutation de la présente invention. Cette application n'est donnée qu'à titre d'exemple, étant entendu que le dispositif de commutation peut être utilisé dans d'autres circuits.

Généralement une alimentation du type commuté comprend un transformateur 1, dont l'enroulement primaire P1 a une prise centrale 2 connectée à une tension continue par exemple +V. Les bornes extrêmes 10 et 11 de l'enroulement P1 sont connectées par deux commutateurs S1 et S2 aux bornes 3 et 4. Dans le cas où la borne 2 est connectée à une tension positive +V, les bornes 3 et 4 sont connectées à la masse. Les commutateurs S1 et S2 sont alternativement fermés par l'intermédiaire de signaux de commande fournis par le circuit 5, si bien qu'un courant circule alternativement entre les bornes 2 et 3 et entre les bornes 2 et 4. Le circuit secondaire comprenant l'enroulement secondaire P2 et un redresseur 6 monté aux bornes de cet enroulement fournit une tension continue sur la sortie 7, cette tension ayant une valeur qui dépend du nombre d'enroulements dans les circuits primaire et secondaire du transformateur.

Le circuit 5 fournit sur ses sorties 8 et 9 des signaux de commande qui sont déphasés de 180° et qui ne se chevauchent pas pour actionner alternativement les dispositifs de commutation S1 et S2.

On va maintenant décrire en référence à la figure 2 le dispositif de commutation de l'invention. Ce dispositif comprend un transistor bipolaire 20 qui dans l'exemple représenté est du type NPN et un transistor à effet de champ qui dans un mode de réalisation préféré est du type V MOS 21. L'émetteur du transistor 20 est relié à la source du transistor 21 et le collecteur du transistor 20 est relié au drain du transistor 21. Les impulsions qui contrôlent l'état du dispositif de commutation sont appliquées à la base du transistor 20 et à la grille du transistor 21 par les bornes 22 et 23 respectivement.

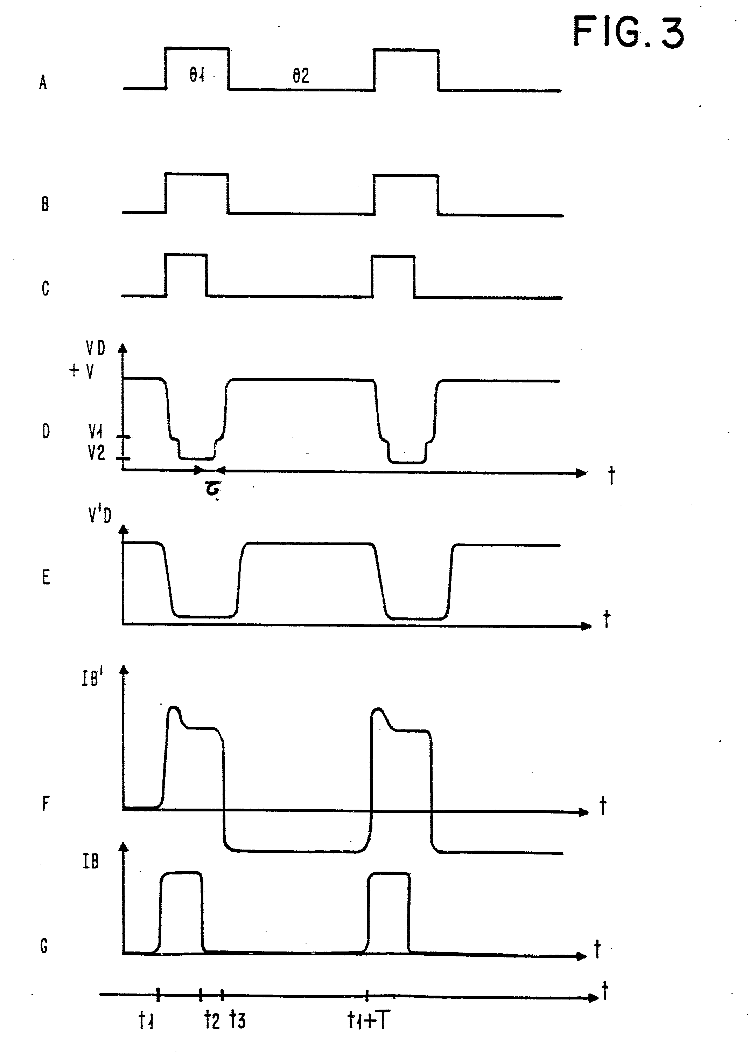

Sur la figure 3 on a représenté les impulsions de commande appliquées aux bornes 22 et 23. Le signal A, représente la commande théorique, c'est-à-dire elle représente le temps $\theta_1$ pendant lequel on veut que l'ensemble de commutation soit dans l'état conducteur et le temps $\theta_2$ pendant lequel on veut que cet ensemble soit dans l'état bloqué.

Le signal B représente la tension de commande appliquée à la grille du transistor V MOS, le signal C représente la tension de commande appliquée à la base du transistor bipolaire. Le signal D représente la tension VD au point commun D du collecteur et du drain des transistors 20 et 21.

Le signal E représente la tension V'D qui serait la tension sur le collecteur d'un transistor bipolaire utilisé seul comme commutateur S1 ou S2, et commandé par un signal de la forme A. Le signal F représente le courant IB' qui devrait être appliqué à la base de ce transistor.

Le signal G représente le courant base IB qui doit être appliqué à la base du transistor 20 de la figure 2.

On va maintenant expliquer en référence aux figures 2 et 3, le fonctionnement du dispositif de commutation de l'invention.

Au temps t1, lorsque les signaux B et C deviennent hauts, les transistors 20 et 21 deviennent conducteurs et en conséquence si ce dispositif est utilisé dans l'arrangement de la figure 1, la tension au point D qui était +V commence à chuter assez rapidement du fait de la vitesse de commutation élevée du transistor 21. Cette tension chute jusqu'à une valeur V1 qui est égale à la tension de saturation du transistor 21, VD reste à cette valeur jusqu'à ce que le transistor 20 soit saturé et à ce moment elle chute à la valeur V2 qui est égale à la tension de saturation du transistor 20 et qui est très voisine de zéro. Au temps t2, le signal C provoque après un temps $\tau$ qui représente le temps nécessaire pour que les charges stockées dans le transistor bipolaire 20 soient évacuées, le blocage du transistor 20, en conséquence, la tension VD remonte au niveau V1 et reste à ce niveau jusqu'au temps t3 où le signal B provoque le blocage du transistor V MOS 21. A ce moment, la tension VD remonte au niveau +V.

On voit donc sur la figure 3, qu'il n'y a pratiquement pas de pertes de commutation et qu'en conséquence la fréquence des impulsions A peut être grande. Des fréquences pouvant aller jusqu'à 500 kHz peuvent être envisagées au lieu de 20 à 50 kHz comme c'est le cas actuellement.

En conséquence, lorsqu'on utilise ce dispositif de commutation dans une alimentation du type représenté sur la figure 1, la taille du transformateur peut être réduite.

De plus du fait qu'il n'y a pratiquement pas de perte de commutation, il n'est pas nécessaire que le transistor bipolaire 20 soit muni de radiateur, ce qui le rend peu encombrant.

Le signal E qui représente la tension V'D qui serait obtenue si il n'y avait pas le transistor 21 et que le commutateur n'était constitué que par un transistor bipolaire commandé par les impulsions A, montre bien les pertes de commutation. De plus dans ce cas il faudrait un courant base ayant la forme représentée par la courbe F avec une pointe au temps t1 pour accélérer la mise à l'état conducteur. Ensuite le courant est maintenu à une valeur inférieure pour maintenir le transistor saturé et au temps t3 il faut un courant négatif pour supprimer les charges stockées et bloquer le transistor. En conséquence dans ce cas la commande du commutateur est compliquée. Par contre du fait que la commutation du transistor 20 dans le dispositif de la figure 2 n'est pas critique, une simple impulsion de courant de la forme représentée par la courbe G c'est-à-dire positive entre t1 et t2 est suffisante. On peut utiliser un transistor bipolaire qui a une tension de claquage moins élevée car lorsqu'on bloque ce transistor la tension à ses bornes est faible étant donné que le transistor 21 est encore conducteur.

Cet arrangement lorsqu'il est utilisé dans l'alimentation du type représenté sur la figure 1 à la place des commutateurs S1 et S2 est monté de la façon suivante. Par exemple pour le commutateur S1, le point commun S entre la source du transistor 21 et l'émetteur du transistor 20 est connecté à la borne 3 et le point D est connecté à la borne 10. De même pour le commutateur S2, le point S est connecté à la borne 4 et le point D est connecté à la borne 11. Le circuit 5 fournit les impulsions de commande aux bornes 23 et 22 de chaque dispositif de commutation, les impulsions pour un des commutateurs étant de la forme représentée sur la figure 3,

0020978

et les impulsions de commande pour l'autre dispositif de commutation étant identiques à celles de la figure 3 mais déphasées de 180°.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

REVENDICATIONS

1. Dispositif de commutation ayant une première position fermée et une seconde position ouverte, commandé par des signaux de commande, caractérisé en ce qu'il comprend:

un premier transistor bipolaire (20) recevant sur sa base un premier signal de commande ayant un premier niveau pour rendre ce transistor conducteur et un second niveau pour le bloquer,

un second transistor à effet de champ (21) recevant sur sa grille un second signal de commande de même fréquence que le premier, et ayant un troisième niveau pour rendre ce transistor conducteur et un quatrième niveau pour le bloquer, le temps pendant lequel le second signal de commande est au troisième niveau étant supérieur à celui pendant lequel le premier signal de commande est au premier niveau, le collecteur du transistor bipolaire étant connecté au drain du transistor à effet de champ et son émetteur étant connecté à la source.

2. Dispositif de commutation selon la revendication 1, caractérisé en ce que le transistor bipolaire est du type NPN et le transistor à effet de champ est du type V MOS.

3. Alimentation de puissance du type commuté comprenant un transformateur (1) dont le primaire est constitué par deux enroulements ayant des premières bornes connectées ensemble à une tension d'alimentation continue et des secondes bornes connectées à une seconde tension continue par l'intermédiaire de deux dispositifs de commutation conforme à la revendication 1 ou 2, dans chaque dispositif de commutation le point commun entre le collecteur du transistor bipolaire et le drain du transistor à effet de champ étant connecté à une des secondes bornes du primaire du transformateur et le point commun entre l'émetteur du transistor bipolaire et la source du transistor à effet de champ étant connectée à la seconde tension d'alimentation.

FIG.1

FIG.2

FIG.3

Office européen des brevets

**RAPPORT DE RECHERCHE EUROPEENNE**

002097 8 Numéro de la demande

EP 80 10 2570

| Catégorie | Citation du document avec indication, en cas de besoin, des parties pertinentes | Revendica-tion concernée |
|---|---|---|
| | US - A - 3 401 319 (WATKINS)<br>* Colonne 1, lignes 55-64;<br>figures 1,2 *<br><br>-- | 1 |
| | US - A - 4 095 252 (OCHI)<br>* De colonne 2, ligne 61 à<br>colonne 3, ligne 27; figure 1 *<br><br>-- | 1,2 |
| | FR - A - 2 406 915 (KREMLEV et al.) 1,2<br>* De page 4, ligne 8 à page 6,<br>ligne 2; figure 1 *<br><br>-- | |
| | US - A - 4 048 649 (BOHN)<br>* De colonne 6, ligne 63 à<br>colonne 7, ligne 27; figure 7 *<br><br>-- | 1,2 |
| | US - A - 3 995 172 (FREEMAN et al.) 1<br>* De colonne 4, ligne 43 à<br>colonne 5, ligne 2; figures<br>1,4,5 *<br><br>-- | |
| | FR - A - 2 100 558 (T.R.T.)<br>* Page 2, lignes 13-36;<br>figure *<br><br>-- | 3 |
| | US - A - 3 530 364 (NELSON et al.) 3<br>* Colonne 2, lignes 6-47;<br>figure *<br><br>--<br>./. | |

**DOCUMENTS CONSIDERES COMME PERTINENTS**

**CLASSEMENT DE LA DEMANDE (Int. Cl. 3)**

H 03 K 17/687
H 01 L 27/06
H 02 M 3/335

**DOMAINES TECHNIQUES RECHERCHES (Int. Cl. 3)**

H 03 K 17/687
        17/04
H 01 L 27/06
H 02 M 3/335
        7/537
H 03 K 3/36
        17/693

**CATEGORIE DES DOCUMENTS CITES**

X: particulièrement pertinent
A: arrière-plan technologique
O: divulgation non-écrite
P: document intercalaire
T: théorie ou principe à la base
   de l'invention
E: demande faisant interférence
D: document cité dans
   la demande
L: document cité pour d'autres
   raisons

&: membre de la même famille,
   document correspondant

Le présent rapport de recherche a été établi pour toutes les revendications

| Lieu de la recherche | Date d'achèvement de la recherche | Examinateur |
|---|---|---|
| La Haye | 11-09-1980 | CANTARELLI |

OEB Form 1503.1 06.78

| DOCUMENTS CONSIDERES COMME PERTINENTS | | | CLASSEMENT DE LA DEMANDE (Int. Cl. 3) |
|---|---|---|---|
| Catégorie | Citation du document avec indication, en cas de besoin, des parties pertinentes | Revendication concernée | |
| | ELECTRONIQUE ET APPLICATIONS INDUSTRIELLES, no. 259, novembre 1978, Paris, FR FILLEAU : "Applications des VMOS: la puissance d'une nouvelle technologie", pages 19-24. <br><br> * Page 21, figure 7; page 22, colonne de droite, quatrième alinéa * | 3 | |
| | ------- | | **DOMAINES TECHNIQUES RECHERCHES (Int. Cl. 3)** |